# EUROPÄISCHE PATENTSCHRIFT

(11) **EP 4 086 588 B1**
(45) Veröffentlichungstag und Bekanntmachung des Hinweises auf die Patenterteilung: **14.06.2023**
(21) Anmeldenummer: 22000116.8
(22) Anmeldetag: 02.05.2022
(51) Int. Cl.: G01D 11/24, H03K 17/95

(54) **SENSORGEHÄUSE**
SENSOR CASING
BOÎTIER DE CAPTEUR

(30) Priorität: 04.05.2021 DE 102021002337
(43) Veröffentlichungstag der Anmeldung: 09.11.2022
(73) Patentinhaber: Pepperl+Fuchs SE, 68307 Mannheim (DE)
(72) Erfinder: Freund, Thomas, 68199 Mannheim (DE); Drebes, Patrick, 68199 Mannheim (DE)
(74) Vertreter: Koch Müller Patentanwaltsgesellschaft mbH

(56) Entgegenhaltungen:
- EP-A1- 3 961 161
- EP-A2- 0 132 661
- DE-C1- 4 412 923
- DE-U1- 8 104 480

## Beschreibung

Die Erfindung betrifft ein Sensorgehäuse umfassend ein Kopfteil mit einem Sensorraum zur Aufnahme eines Sensors und ein Anschlussteil mit einem Klemmraum zur Aufnahme eines Klemmanschlussblocks.

Aus der nicht vorveröffentlichten EP 3 961 161 A1 ist ein Sensorgehäuse mit einem einen Sensorraum zur Aufnahme eines Sensors aufweisenden Kopfteil und ein einen Klemmraum aufweisenden Anschlussteil bekannt, wobei in dem Klemmraum ein Klemmanschlussblock angeordnet ist. Das Kopfteil ist mittels eines Verbindungsteils mit dem Anschlussteil verbunden, wobei das Verbindungsteil durch eine Führungsöffnung in einer ersten Seitenwand des Anschlussteils in das Anschlussteil hineinragt. Das Verbindungsteil weist eine Durchgangsöffnung zur Durchführung elektrischer Verbindungen, z.B. Kabel oder Stifte zwischen dem Sensorraum und dem Klemmraum auf. Außerdem weist das Anschlussteil in einer zweiten Seitenwand eine Eingangsöffnung zur Kabeldurchführung von außen in den Klemmraum auf.

Ferner weist das Verbindungsteil gemäß dieser nicht vorveröffentlichten EP 3 961 161 A1 an einem von dem Kopfteil abgewandten Ende einen Rückhalteabschnitt mit einer ersten Außenweite und einen Mittenabschnitt mit einer zweiten Außenweite auf, wobei die erste Außenweite größer als die zweite Außenweite und größer als die Weite der Führungsöffnung ist. Die zweite Au-ßenweite ist jedoch kleiner als die Weite der Führungsöffnung. Der Rückhalteabschnitt des Verbindungsteils weist eine dem Kopfteil zugewandte erste Anschlagsfläche weist, während das Anschlussteil eine zweite Anschlagsfläche als Gegenstück zu der ersten Anschlagsfläche des Verbindungsteils aufweist.

Schließlich weist das Anschlussteil gemäß dieser nicht vorveröffentlichten EP 3 961 161 A1 zweiteilig mit einem Klemmraumunterteil und einem Klemmraumdeckel ausgebildet, wobei das Klemmraumunterteil einen Sperrbereich mit einer an die erste Anschlagsfläche des Rückhalteabschnitts des Verbindungsteils angrenzenden Seitenfläche aufweist, so dass das Verbindungsteil bei von dem Klemmraumdeckel getrenntem Klemmraumunterteil zwischen einer ersten Position mit aufeinanderliegender erster Anschlagsfläche des Verbindungsteils und zweiter Anschlagsfläche und einer zweiten Position mit an dem Klemmraumdeckel anliegender Kopfteil bewegbar ist und das Verbindungsteil bei mit dem Klemmraumunterteil verbundenem Klemmraumdeckel in der zweiten Position fixiert ist.

Eine typische Bauform von Sensoren, wie induktiven oder kapazitativen Näherungssensoren, umfasst ein zweiteiliges Gehäuse. Der Sensor ist in einem Kopfteil angeordnet und in einem Anschlussteil wird eine Kontaktiervorrichtung, z.B. ein Klemmanschlussblock, zum Anschließen eines von außen kommenden Kabels angeordnet. Das Anschlussteil bzw. der von dem Anschlussteil umfasste Raum wird daher häufig auch als Klemmraum bezeichnet.

Der Sensor in dem Kopfteil ist durch elektrische Leitungen mit der Kontaktiervorrichtung verbunden, wofür das Kopfteil und das Anschlussteil entsprechende Durchgangsöffnungen und gegebenenfalls weitere Kontaktiervorrichtungen, wie z.B. Kontaktstifte, umfassen.

Das Kopfteil ist meist in unterschiedlichen Ausrichtungen, d.h. Drehpositionen, mit dem Anschlussteil verbindbar, um das Ausrichten des in dem Kopf angeordneten Sensors zu ermöglichen. Dies ist mit unterschiedlichem Aufwand möglich.

Die Kopfteile des induktiven Näherungssensors NBB20-U1-UU oder des kapazitiven Sensors CJ15+U1+A2 der Fa. Pepperl + Fuchs GmbH weisen jeweils ein quaderförmiges Verbindungsteil mit einer umlaufenden Nut auf. Das Verbindungsteil reicht durch eine entsprechende Durchgangsöffnung in einen Deckel des Anschlussteils hinein. Eine feste Verbindung zwischen dem Kopfteil und dem Deckel des Anschlussteils wird durch einen Formschluss eines verschiebbaren Wandabschnitts des Deckels und zweier an dem Verbindungsteil vorbeilaufender Schraubenhälse mit der Nut erreicht. Mittels der Schrauben wird der Deckel mit einem Boden des Anschlussteils verbunden.

Um die Ausrichtung des Kopfteils zu ändern, müssen die Schrauben gelöst und damit der Boden von dem Deckel des Anschlussteils gelöst werden. Außerdem muss der verschiebbare Wandabschnitt mittels der Schrauben aus der Nut herausgezogen werden. Kopfteil und Deckel des Anschlussteils sind dann nur noch über die elektrischen Leitungen miteinander verbunden.

Die Baureihe IQ40 der Fa. SICK AG, z.B. der induktive Näherungssensor IQ40-NPPKKOS ist in einer Standardbauform ähnlich aufgebaut und das Ausrichten des Kopfteils ähnlich aufwendig. In einer Kurzbauform wird ein Kopfteil ohne Anschlussteil bereitgestellt, welches direkt mit einer Halterung verbunden werden kann. Zum Ausrichten des Kopfteils kann dieses mittels eines Druckknopfs (als Push-Lock-Systems bezeichnet) in einfacher Weise von der Halterung gelöst, gedreht und wieder eingesetzt werden.

Der induktive Näherungssensor XS8C4A1PCG13 der zu der Fa. Schneider Electric SE gehörenden Marke Telemecanique Sensors weist einen mechanischen Riegel auf. Das Kopfteil muss für das Ausrichten nicht vollständig von dem Anschlussteil getrennt werden. Vielmehr kann das Kopfteil nach Herausziehen des Riegels in einer geführten Bewegung ein Stück von dem Anschlussteil entfernt werden, wodurch eine Fixierschraube am Kopfteil zugänglich wird und ein Teilbereich des Kopfteils nach Lösen der Fixierschraube gedreht werden kann.

Von der Fa. Rockwell Automation, Inc. sind Näherungssensoren, z.B. das Modell 871L oder 872L DC, mit einem Kopfteil und einem Anschlussteil bekannt, wobei der Deckel des Anschlussteils eine Deckplatte aufweist, welches als Entriegelungshebel zum Entriegeln einer Verbindung zwischen Deckel und Boden des Anschlussteils dient.

Aus der EP 0 132 661 A2 ist ein Sensorgehäuse für einen kontaktlosen Schalter bekannt. Das Sensorgehäuse ist zweiteilig mit einem aus einem Befestigungsteil und einem Steuerteil aufgebauten Kopfteil sowie einem mit dem Kopfteil verbindbaren zweiteiligen Anschlussteil ausgeführt. In dem Kopfteil ist ein Sensor verbaut, während das Anschlussteil für den elektrischen Anschluss ausgebildet ist. Bei diesem bekannten Sensorgehäuse ist an dem Befestigungsteil ein Verbindungsteil angeordnet, welches mit einer Sacklochbohrung eines Oberteils des Anschlussteils zusammenwirkt. Das Anschlussteil weist eine Kabeldurchführung auf, die über eine Bohrung im Boden der Sacklochbohrung bis in den Innenraum des Anschlussteils geführt ist. Die Verbindung des Verbindungsteils mit dem Oberteil des Anschlussteils erfolgt mittels einer Rasthaken aufweisenden Schnappverbindung. Mit dem Einführen des Verbindungsteils in die Sacklochbohrung des Oberteils greifen die Rasthaken in eine in der Innenwandung der Sacklochbohrung umlaufenden Nut, die in axialer Richtung eine Länge aufweist, die es ermöglich, dass das Verbindungsteil zusammen mit dem Befestigungsteil in axialer Richtung zwischen zwei Positionen verschiebbar ist, um eine Drehung des Befestigungsteils gegenüber dem Anschlussteil zu ermöglichen. In der vollständig in das Sacklochbohrung eingeschobenen Position wird das Verbindungsteil mittels eines Sperrbereichs eines Unterteils des Anschlussteils fixiert, wenn die beiden Teile des Anschlussteils verbunden werden. Ein Mittenabschnitt des Verbindungsteils zwischen den Rasthaken und einer Rückwandaußenfläche des Befestigungsteils des Kopfteils weist um 90° versetzte Nuten auf, in die ein konturangepasster Ansatz des Unterteils des Anschlussteils als Sperrbereich hineinragt und damit eine Verdrehung des Befestigungsteils gegenüber dem Anschlussteil verhindert wird. Die Verbindungsmechanik zur Verbindung des Kopfteils mit dem Anschlussteil, welches eine Drehbewegung zwischen den beiden Komponenten erlaubt, ist konstruktiv aufwendig und damit bei der Herstellung mit hohen Kosten verbunden.

Aus der DE 44 12 923 C1 ist ein elektrischer Schalter mit einem Tastkopf bekannt. Das Schaltergehäuse besteht aus einem Unterteil und einem Oberteil, die ausschließlich durch Rastelemente lösbar miteinander verbunden sind. Ein Befestigungsteil des Tastkopfes ist mittels eines Lagerzapfens drehbar im Oberteil gelagert und in diesem mittels einer Halterung fixiert. Auf dem Oberteil ist ein Deckel verrastbar, der in seiner Schließstellung die Rastverbindungen zwischen Ober- und Unterteil in der Raststellung sowie die Halterung in der Fixierstellung blockiert.

Schließlich beschreibt die DE 81 04 480 U1 einen berührungslos wirkenden Schalter mit einem im wesentlichen quaderförmigen, die elektrische Schaltungsanordnung umschließenden und mit Anschlussklemmen versehenen Anschlussgehäuse mit Deckel sowie einem wenigstens die Fühlerspule enthaltenden, am Anschlussgehäuse lösbar befestigten etwa würfelförmigen Tastkopf, der mit seiner Fühlerspule in mehreren Stellungen in Gehäuselängsrichtung und quer zur Gehäuselängsrichtung anbringbar ist. Der Tastkopf besteht aus zwei etwa haubenartigen und bündig ineinander steckbaren Gehäuseteilen, von denen der äußere Teil eine der offenen Seite benachbarte durch einen Deckel verschlossene Seite aufweist und an dem inneren, mindestens die Fühlerspule haltenden Gehäuseteil, an einer Seite des Außenteils zugeordneten Außenfläche ein im Querschnitt vier-, sechs- oder achteckiger Sockel lösbar befestigt und in eine entsprechende Fassung des Anschlussgehäuses einsteckbar ist.

Vor diesem Hintergrund besteht die Aufgabe der Erfindung darin, eine Vorrichtung anzugeben, die den Stand der Technik weiterbildet.

Insbesondere soll ein Sensorgehäuse mit einem einfachen, intuitiv zugänglichen und werkzeuglos bedienbaren Mechanismus für die Verbindung zwischen Sensorkopf und Anschlussteil bzw. zur Ausrichtung des Sensorkopfs relativ zu einem Anschlussteil bereitgestellt werden.

Die Aufgabe wird durch eine Vorrichtung mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Sensorgehäuse, umfassend ein Kopfteil mit einem Sensorraum zur Aufnahme eines Sensors und ein Anschlussteil mit einem Klemmraum zur Aufnahme eines Klemmanschlussblocks bereitgestellt, wobei das Kopfteil eine Rückwand mit einer Rückwandaußenfläche und ein auf der Rückwandaußenfläche angeordnetes Verbindungsteil aufweist.

Das Verbindungsteil weist entlang einer senkrecht zu der Rückwandaußenfläche verlaufenden Verbindungsachse an einem von der Rückwandaußenfläche abgewandten Ende einen Rückhalteabschnitt mit einem ersten Außendurchmesser D1 auf.

Außerdem weist das Verbindungsteil in einem sich zwischen der Rückwandaußenfläche und dem Rückhalteabschnitt erstreckenden Mittenabschnitt einen zweiten Außendurchmesser D2 auf.

Der erste Außendurchmesser D1 ist größer als der zweite Außendurchmesser D2.

Das Kopfteil weist eine entlang der Verbindungsachse durch das Verbindungsteil und die Rückwand verlaufende Durchgangsöffnung zur Kabel- und/oder Steckerdurchführung in den Sensorraum auf.

Das Anschlussteil ist zweiteilig mit einem Klemmraumunterteil und einem Klemmraumdeckel mit jeweils umlaufender Dichtfläche ausgebildet, wobei das Klemmraumunterteil und der Klemmraumdeckel den Klemmraum umschließen.

Das Klemmraumunterteil weist einen Boden und mindestens eine erste Seitenwand auf.

Die erste Seitenwand weist eine Eingangsöffnung zur Kabel- und/oder Steckerdurchführung in den Klemmraum auf.

Der Klemmraumdeckel weist eine Decke und mindestens eine erste Seitenwand auf.

Die erste Seitenwand weist eine Führungsöffnung mit einem dritten Durchmesser D3 auf. Das Verbindungsteil des Kopfteils ragt durch die Führungsöffnung des Klemmraumdeckels in das Anschlussteil hinein.

Der erste Außendurchmesser D1 des Rückhalteabschnitts des Verbindungsteils ist größer als der dritte Durchmesser D3 der Führungsöffnung und der zweite Außendurchmesser D2 des Mittenabschnitts des Verbindungsteils ist kleiner als der dritte Durchmesser D3 der Führungsöffnung.

Der Rückhalteabschnitt des Verbindungsteils weist eine der Rückwandaußenfläche des Kopfteils zugewandte erste Anschlagfläche auf und das Anschlussteil weist an einer Innenfläche der ersten Seitenwand um die Führungsöffnung herum eine zweite Anschlagsfläche als Gegenstück zu der ersten Anschlagsfläche des Verbindungsteils auf.

Außerdem weist das Klemmraumunterteil einen Sperrbereich mit einer an die erste Anschlagsfläche des Rückhalteabschnitts des Verbindungsteils angrenzenden Seitenfläche auf, so dass das Verbindungsteil bei von dem Klemmraumdeckel getrenntem Klemmraumunterteil zwischen einer ersten Position mit aufeinanderliegender erster und zweiter Anschlagsfläche und einer zweiten Position mit an der ersten Seitenwand des Klemmraumdeckels anliegender Rückwandaußenfläche des Kopfteils bewegbar ist und bei mit dem Klemmraumunterteil verbundenem Klemmraumdeckel in der zweiten Position fixiert ist, in welcher die beiden Dichtflächen formschlüssig miteinander verbunden sind.

Ist das Anschlussteil geöffnet, so begrenzt die Führungsöffnung des Klemmraumdeckels zusammen mit dem Rückhalteabschnitt des Verbindungsteils die Bewegung des Kopfteils relativ zu dem Klemmraumdeckel, so dass sich das Kopfteil nicht vollständig von dem Klemmraumdeckel lösen lässt.

Hierfür greift das am Kopfteil angeordnete Verbindungsteil durch die Führungsöffnung des Klemmraumdeckels, so dass sich der Rückhalteabschnitt innerhalb des Anschlussteils, beispielsweise innerhalb des Klemmraums, befindet.

Hierdurch werden zwischen dem Kopfteil und dem Anschlussteil verlaufende Leitungen/Kabel und/oder Steckverbindungen nicht unnötig belastet. Das Kopfteil lässt sich hierbei aber soweit von dem Anschlussteil entfernen, dass ein Drehen des gesamten Kopfteils oder ein Drehen eines Teils des Kopfteils möglich wird.

Es versteht sich, dass der Sperrbereich des Klemmraumunterteils zumindest mit einem Teil des Rückhalteabschnitts des Verbindungsteils einen Formschluss ausbildet. Durch den Formschluss wird die Position des Kopfteils relativ zu dem Anschlussteil fixiert, sobald Klemmraumunterteil und Klemmraumdeckel verbunden werden.

Das Klemmraumunterteil lässt sich mit dem Klemmraumoberteil dicht verbinden. Hierzu ist an beiden Teilen eine umlaufende Dichtfläche ausgebildet, wobei die beiden Dichtflächen in der zweiten Position formschlüssig miteinander verbunden sind.

Andererseits ist lediglich das Lösen der Verbindung zwischen Klemmraumunterteil und Klemmraumdeckel notwendig, um eine Beweglichkeit des Kopfteils gegenüber dem Klemmraumdeckel zu ermöglichen. Ein weiterer Entriegelungsvorgang oder ähnliches ist nicht notwendig. Hierdurch ist das Ausrichten des Kopfteils relativ zu dem Anschlussteil besonders einfach durchführbar.

Ferner versteht es sich, dass eine Beweglichkeit des Kopfteils bei von dem Klemmraumdeckel getrenntem Klemmraumunterteil gegenüber dem Klemmraumdeckel in gewissem Rahmen sowohl entlang der Verbindungachse als auch quer zu der Verbindungsachse und um die Verbindungsachse herum gegeben ist. Die Bewegung entlang der Verbindungachse wird insbesondere durch den Rückhalteabschnitt begrenzt. Die Beweglichkeit quer zu der Verbindungachse hängt von der Wandstärke der ersten Seitenwand des Klemmraumdeckels und von dem Verhältnis des Durchmessers der Führungsöffnung zu dem Durchmesser des Mittelabschnitts ab.

Es wird angemerkt, dass die Führungsöffnung nicht geschlossen sein muss bzw. das Verbindungsteil nicht vollständig, also nicht um 360°, umschließen muss. Der Begriff Führungsöffnung wird vielmehr für eine Öffnung im Klemmraumdeckel verwendet, welche das Verbindungsteil des Kopfteils zumindest soweit umschließt, dass sich das Kopfteil bei entferntem Klemmraumunterteil nicht von dem Klemmraumdeckel lösen lässt.

Außerdem versteht es sich, dass sowohl das Kopfteil als auch Klemmraumunterteil und Klemmraumoberteil jeweils einstückig oder auch mehrstückig ausgebildet sein können. Insbesondere ist die erste Seitenwand des Klemmraumdeckels mit der Führungsöffnung gemäß einer Weiterbildung als zweiteiliges separates Bauteil ausgebildet, wodurch die Montage des Kopfteils in dem Klemmraumdeckel vereinfacht werden kann.

Ein Vorteil des erfindungsgemäßen Sensorgehäuses ist, dass zwischen dem Kopfteil und dem Anschlussteil verlaufende Leitungen/Kabel und/oder Steckverbindungen auch bei von dem Klemmraumunterteil gelöstem Klemmraumdeckel nicht belastet werden.

Außerdem ist das erfindungsgemäße Sensorgehäuse besonders einfach und damit kostengünstig herstellbar, da kein zusätzlicher Verriegelungsmechanismus notwendig ist, sondern die Beweglichkeit zwischen Kopfteil und Anschlussteil direkt mit dem Öffnen/Schließen des Anschlussteils bzw. des Klemmraums verknüpft ist.

Es sei angemerkt, dass mit dem Begriff "kein zusätzlicher Verriegelungsmechanismus" eine Verbindung zwischen Klemmraumunterteil und Klemmraumoberteil insbesondere ohne extra Schrauben oder Federn oder Klemmen zu verstehen ist.

Vorzugsweise sind an einem oder beiden Teilen Formteile zum verbinden bzw. halten wie beispielsweise Rastnasen oder ähnliches ausgebildet sind. Die jeweiligen Formteile sind jeweils einstückig mit dem Klemmraumoberteil oder mit dem Klemmraumunterteil verbunden.

Es versteht sich, dass sich das Klemmraumunterteil von dem Klemmraumoberteil werkzeuglos zusammenfügen und trennen lassen.

Gemäß einer Weiterbildung ist in einem unmittelbar an die Rückwandaußenfläche angrenzenden Bereich des Mittenabschnitts des Verbindungsteils mindestens eine Justierhilfe angeordnet und die erste Seitenwand des Klemmraumdeckels weist auf einer Außenfläche mindestens eine sich unmittelbar an die Führungsöffnung anschließende und der Form nach der Justierhilfe entsprechende Ausnehmungen auf.

Die Justierhilfen und die entsprechende Ausnehmung in der Außenfläche der ersten Seitenwand des Klemmraumdeckels sind beispielsweise als quaderförmiger Körper bzw. entsprechend rechteckige Ausnehmung ausgebildet. Die Ausnehmung stellt ein präzises Positionieren des Kopfteils relativ zu dem Anschlussteil sicher.

Gemäß einer Weiterbildung weist die Seitenwand des Klemmraumdeckels mehrere Ausnehmungen auf, wodurch das Kopfteil in mehreren jeweils präzise erreichbaren Positionen zu dem Anschlussteil ausgerichtet werden kann.

Es versteht sich, dass die Ausnehmungen in die Durchgangsöffnung übergehen und je nach Wandstärke der ersten Seitenwand des Klemmraumdeckels und Größe (insbesondere Tiefe) der Justierhilfe die Ausnehmungen die erste Seitenwand auch vollständig durchdringen können.

Gemäß einer weiteren Ausführungsform weist das Führungsloch und ein unmittelbar an die Rückwandaußenfläche angrenzender Bereich des Mittenabschnitts jeweils eine mindestens zweizählige Drehsymmetrie oder eine mindestens vierzählige Drehsymmetrie aufweist.

Eine solche Drehsymmetrie wird beispielsweise durch Justierhilfen, wie Justiernasen, bzw. durch weitere an eine kreisförmige Führungsöffnung angrenzende Ausnehmungen umgesetzt. Die Wertigkeit der Drehsymmetrie gibt die möglichen Positionen des Kopfteils relativ zu dem Anschlussteil vor.

Gemäß einer anderen Ausführungsform ist das Verbindungsteil zylinderförmig ausgebildet. Eine zylinderförmige Ausführung mit einem ersten konstanten Außendurchmesser und mindestens einem zweiten kontanten Außendurchmesser entlang einer Längsachse stellt eine besonders einfache Ausführungsform des Verbindungsteils dar.

In einer weiteren Ausführungsform entspricht das Sensorgehäuse dem IP 68 Standard oder dem IP 69K Standard.

Gemäß dem Gegenstand der Erfindung wird auch ein induktiver oder kapazitiver Näherungssensor bereitgestellt, wobei der Näherungssensor ein Sensorgehäuse gemäß einem der vorangegangenen Ansprüche aufweist.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckung ist nicht maßstäblich und weisen, sofern nicht anders angegeben, auch keine ableitbaren geometrischen Relationen zueinander auf. Darin zeigen, die
- Figur 1: einen Querschnitt einer ersten erfindungsgemäßen Ausführungsform eines Sensorgehäuses,
- Figur 2: eine Ansicht eines Anschlussteils gemäß einer ersten erfindungsgemäßen Ausführungsform,
- Figur 3: eine perspektivische Ansicht eines Kopfteils gemäß einer ersten erfindungsgemäßen Ausführungsform,
- Figur 4: eine Ansicht eines Anschlussteils gemäß einer weiteren erfindungsgemäßen Ausführungsform.

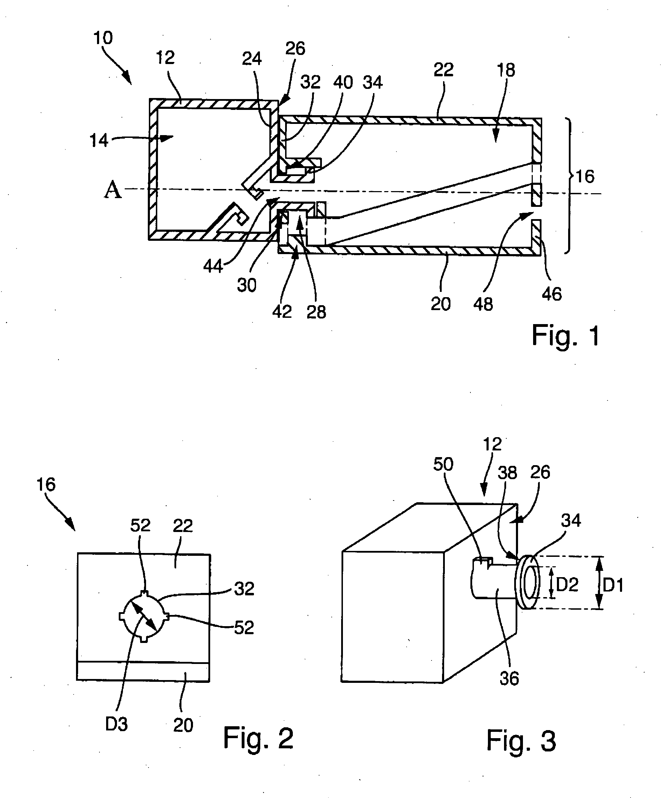

Die Abbildung der Figur 1 zeigt einen Querschnitt eines Sensorgehäuses 10 gemäß einer ersten Ausführungsform, umfassend ein Kopfteil 12 mit einem Sensorraum 14 zur Aufnahme eines Sensors (nicht dargestellt) und ein Anschlussteil 16 mit einem Klemmraum 18 zur Aufnahme eines Klemmanschlussblocks (nicht dargestellt). Eine seitliche Ansicht einer ersten Ausführungsform des Anschlussteils 16 ist in Figur 2 dargestellt. In Figur 3 ist eine perspektivische Ansicht einer ersten Ausführungsform des Kopfteils 12 dargestellt.

Das Anschlussteil 16 ist zweiteilig mit einem Klemmraumunterteil 20 und einem Klemmraumdeckel 22 ausgebildet. In der Abbildung der Figur 1 sind das Klemmraumunterteil 20 und der Klemmraumdeckel 22 voneinander getrennt. Wird der Klemmraumdeckel 22 entlang der gepunkteten Linien auf das Klemmraumunterteil 20 aufgesetzt, so umschließen das Klemmraumunterteil 20 und der Klemmraumdeckel 22 den Klemmraum 18.

Das Kopfteil 12 ist mit dem Klemmraumdeckel 22 mittels eines Verbindungsteils 28 verbunden. Das Verbindungsteil 28 ist an einer Außenfläche 26 einer Rückwand 24 des Kopfteils angeordnet und reicht zumindest teilweise durch eine Führungsöffnung 30 in einer ersten Seitenwand 32 des Klemmraumdeckels 22 in den Klemmraum 18 des Anschlussteils 16 hinein.

Das Verbindungsteil 28 weist entlang einer senkrecht zu der Rückwandaußenfläche 26 verlaufenden Verbindungsachse A an einem von der Rückwandaußenfläche 26 abgewandten Ende einen Rückhalteabschnitt 34 auf.

Ein sich zwischen der Rückwandaußenfläche 26 und dem Rückhalteabschnitt 34 erstreckenden Mittenabschnitts 36 des Verbindungsteils 28 weist einen zweiten Außendurchmesser D2 auf, wobei der zweite Außendurchmesser D2 kleiner als ein dritter Durchmesser D3 der Führungsöffnung 30 in dem Klemmraumdeckel 22 ist. Der Rückhalteabschnitt 34 des Verbindungsteils 28 weist einen ersten Außendurchmesser D1 auf, wobei der erste Außendurchmesser D1 größer als der dritte Durchmesser D3 der Führungsöffnung 30 ist.

Der Rückhalteabschnitt 34 verhindert dadurch ein vollständiges Lösen des Kopfteils 12 von dem Klemmraumdeckel 22 des Anschlussteils 16.

Außerdem weist der Rückhalteabschnitt 34 des Verbindungsteils 28 eine der Rückwandaußenfläche 26 des Kopfteils 12 zugewandte erste Anschlagfläche 38 auf. Das Anschlussteil 16 weist an einer Innenfläche der ersten Seitenwand 32 um die Führungsöffnung 30 herum eine zweite Anschlagsfläche 40 als Gegenstück zu der ersten Anschlagsfläche 38 des Verbindungsteils 28 auf.

Bei getrenntem Klemmraumunterteil 20, wie in der Abbildung der Figur 1 dargestellt, erlaubt das Verbindungsteil 28 zusammen mit der Führungsöffnung 30 damit eine geführte Bewegung des Kopfteils 12 relativ zu dem Anschlussteil 16 zwischen einer ersten Position mit aufeinanderliegender erster und zweiter Anschlagsfläche 38, 40 und einer zweiten Position mit an der ersten Seitenwand 32 des Klemmraumdeckels 22 anliegender Rückwandaußenfläche 26 des Kopfteils 12.

Durch das Schließen des Klemmraums 18 bzw. das Verbinden von Klemmraumunterteil 20 und Klemmraumdeckel 22 wird die Bewegung unterbunden und das Kopfteil und Anschlussteil in der zweiten Position fixiert.

Hierfür weist das Klemmraumunterteil 20 einen Sperrbereich 42 mit Seitenfläche auf, wobei die Seitenfläche an die erste Anschlagsfläche 38 des Rückhalteabschnitts 34 des Verbindungsteils 28 angrenzt und dadurch die Position des Kopfteils gegenüber dem Anschlussteil fixiert.

In dem dargestellten Ausführungsbeispiel passt der Sperrbereich 42 formschlüssig zwischen die zweite Anschlagsfläche 40 der Führungsöffnung 30 und die erste Anschlagsfläche 38 des Rückhalteabschnitts 34 des Verbindungsteils 28. Gemäß einer nicht dargestellten alternativen Ausführungsform könnte der Sperrbereich 42 aber auch kleiner ausgebildet sein, solange die Seitenfläche an einen Teil der ersten Anschlagsfläche 38 des Rückhalteabschnitts 34 angrenzt.

Um einen in dem Sensorraum 14 angeordneten Sensor mit einem in dem Klemmraum 18 angeordneten Klemmanschlussblock mittels Leitungen und/oder Steckverbindungen verbinden zu können, weist das Kopfteil 12 eine entlang der Verbindungsachse A durch das Verbindungsteil 28 und die Rückwand 24 verlaufende Durchgangsöffnung 44 zur Kabel- und/oder Steckerdurchführung in den Sensorraum auf.

Außerdem weist das Klemmraumunterteil 20 einen Boden und mindestens eine erste Seitenwand 46 auf, wobei die erste Seitenwand 46 eine Eingangsöffnung 48 zur Kabel- und/oder Steckerdurchführung in den Klemmraum aufweist.

Gemäß einer Ausführungsform des erfindungsgemäßen Sensorgehäuses 10 weist das Kopfteil 12 eine Nase bzw. einen Vorsprung als Justierhilfe 50 auf. Die Justierhilfe 50 ist in einem unmittelbar an die Rückwandaußenfläche 26 angrenzenden Bereich des Mittenabschnitts 36 des Verbindungsteils 28 angeordnet (Fig. 3).

Unmittelbar an die Führungsöffnung 30 in dem Klemmraumdeckel 22 angrenzend weist das Sensorgehäuse 10 gemäß der dargestellten Ausführungsform vier Ausnehmungen 52 auf (Fig. 2). Die Ausnehmungen sind gleichmäßig um einen Umfang der Führungsöffnung 30 verteilt.

Die Führungsöffnung 30 mit den Ausnehmungen 52 weist somit eine vierzählige Drehsymmetrie auf. Die Form der Ausnehmung ist ein Negativ der Form der Justierhilfe. Durch die Justierhilfen wird die Position des Kopfteils in Bezug auf eine Drehung um die Verbindungsachse relativ zu dem Anschlussteil vorgegeben.

In dem dargestellten Ausführungsbeispiel sind durch die vier Ausnehmungen in Kombination mit einer Justierhilfe genau vier Positionen möglich.

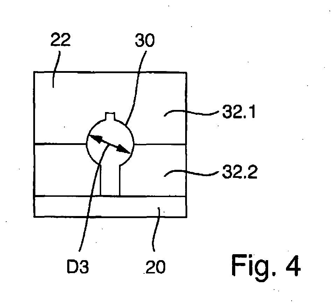

In der Abbildung der Figur 4 ist eine weitere Ausführungsform des Anschlussteils 16 eines erfindungsgemäßen Sensorgehäuses dargestellt. Im Folgenden werden nur die Unterschiede zu der Abbildung der Figur 2 erläutert.

Die Durchgangsöffnung 30 in der Seitenwand 32 des Klemmraumdeckels 22 umschließt keine 360°, sondern ist zu einer unteren Kante des Klemmraumdeckels 22 hin offen.

## Patentansprüche

1. Sensorgehäuse (10), umfassend ein Kopfteil mit einem Sensorraum (14) zur Aufnahme eines Sensors und ein Anschlussteil (16) mit einem Klemmraum (18) zur Aufnahme eines Klemmanschlussblocks, wobei
- das Kopfteil (12) eine Rückwand mit einer Rückwandaußenfläche (26) und ein auf der Rückwandaußenfläche (26) angeordnetes Verbindungsteil (28) aufweist,
- das Verbindungsteil (28) entlang einer senkrecht zu der Rückwandaußenfläche (26) verlaufenden Verbindungsachse (A) an einem von der Rückwandaußenfläche (26) abgewandten Ende einen Rückhalteabschnitt (34) mit einem ersten Außendurchmesser D1 aufweist,
- das Verbindungsteil (28) in einem sich zwischen der Rückwandaußenfläche (26) und dem Rückhalteabschnitt (34) erstreckenden Mittenabschnitt (36) einen zweiten Außendurchmesser D2 aufweist,
- der erste Außendurchmesser D1 größer als der zweite Außendurchmesser D2 ist,
- das Kopfteil (12) eine entlang der Verbindungsachse durch das Verbindungsteil (28) und die Rückwand verlaufende Durchgangsöffnung (44) zur Kabel- und/oder Steckerdurchführung in den Sensorraum (14) aufweist,
- das Anschlussteil (16) zweiteilig mit einem Klemmraumunterteil (20) und einem Klemmraumdeckel (22) mit jeweils umlaufender Dichtfläche ausgebildet ist,
- das Klemmraumunterteil (20) und der Klemmraumdeckel (22) den Klemmraum (18) umschließen,
- das Klemmraumunterteil (20) einen Boden und mindestens eine erste Seitenwand (46) aufweist und die erste Seitenwand (46) eine Eingangsöffnung (48) zur Kabel- und/oder Steckerdurchführung in den Klemmraum (18) aufweist,
- der Klemmraumdeckel (22) eine Decke und mindestens eine erste Seitenwand (32) aufweist und die erste Seitenwand (32) eine Führungsöffnung (30) mit einem dritten Durchmesser D3 aufweist,
- das Verbindungsteil (28) des Kopfteils (12) durch die Führungsöffnung (30) des Klemmraumdeckels (22) in das Anschlussteil (16) hineinragt,
- der erste Außendurchmesser D1 des Rückhalteabschnitts des Verbindungsteils (28) größer als der dritte Durchmesser D3 der Führungsöffnung (30) ist,
- der zweite Außendurchmesser D2 des Mittenabschnitts (36) des Verbindungsteils (28) kleiner als der dritte Durchmesser D3 der Führungsöffnung (30) ist,
- der Rückhalteabschnitt (34) des Verbindungsteils (28) eine der Rückwandaußenfläche (26) des Kopfteils (12) zugewandte erste Anschlagfläche (38) aufweist,
- das Anschlussteil (16) an einer Innenfläche der ersten Seitenwand (32) um die Führungsöffnung (30) herum eine zweite Anschlagsfläche (40) als Gegenstück zu der ersten Anschlagsfläche (38) des Verbindungsteils (28) aufweist,
- das Klemmraumunterteil (20) einen Sperrbereich (42) mit einer an die erste Anschlagsfläche (38) des Rückhalteabschnitts des Verbindungsteils angrenzenden Seitenfläche aufweist,
- so dass das Verbindungsteil (28) bei von dem Klemmraumdeckel (22) getrenntem Klemmraumunterteil (20) zwischen einer ersten Position mit aufeinanderliegender erster Anschlagsfläche (38) des Verbindungsteils (28) und zweiter Anschlagsfläche (40) der Seitenwand (32) und einer zweiten Position mit an der ersten Seitenwand (32) des Klemmraumdeckels (22) anliegender Rückwandaußenfläche (26) des Kopfteils (12) bewegbar ist und das Verbindungsteil (28) bei mit dem Klemmraumunterteil (20) verbundenem Klemmraumdeckel (22) in der zweiten Position fixiert ist, in welcher die beiden Dichtflächen formschlüssig miteinander verbunden sind.

2. Sensorgehäuse (10) nach Anspruch 1, **dadurch gekennzeichnet, dass** das in einem unmittelbar an die Rückwandaußenfläche (26) angrenzenden Bereich des Mittenabschnitts (36) des Verbindungsteils (28) mindestens eine Justierhilfe (50) angeordnet ist und die erste Seitenwand (32) des Klemmraumdeckels (22) auf einer Außenfläche mindestens eine sich unmittelbar an die Führungsöffnung (30) anschließende und der Form nach der Justierhilfe (50) entsprechende Ausnehmungen (52) aufweist.

3. Sensorgehäuse (10) nach Anspruch 2, **dadurch gekennzeichnet, dass** die Führungsöffnung (30) und ein unmittelbar an die Rückwandaußenfläche (26) angrenzender Bereich des Mittenabschnitts (36) jeweils eine mindestens zweizählige Drehsymmetrie oder eine mindestens vierzählige Drehsymmetrie aufweist.

4. Sensorgehäuse (10) nach einem der vorangegangenen Ansprüche, **dadurch gekennzeichnet, dass** das Verbindungsteil (28) zylinderförmig ausgebildet ist.

5. Induktiver Näherungssensor oder kapazitiver Näherungssensor, wobei der Näherungssensor ein Sensorgehäuse (10) gemäß einem der vorangegangenen Ansprüche aufweist.

## Claims

1. Sensor casing (10) comprising a head part with a sensor chamber (14) for reception of a sensor and a terminal part (16) with a terminal chamber (18) for reception of a terminal connecting block, wherein
- the head part (12) has a back wall with a back wall outer surface (26) and a connecting part (28) arranged on the back wall outer surface (26),
- the connecting part (28) has a retaining section (34), which has a first outer diameter D1, along a connecting axis (A), which extends perpendicularly to the back wall outer surface (26), at an end remote from the back wall outer surface (26),
- the connecting part (28) has a second outer diameter D2 in a middle section (36) extending between the back wall outer surface (26) and the retaining section (34),
- the first outer diameter D1 is larger than the second outer diameter D2,
- the head part (12) has a passage opening (44), which extends along the connecting axis through the connecting part (28) and the back wall, for cable and/or plug passage into the sensor chamber (14),
- the connecting part (16) is of two-part construction with a terminal chamber lower part (20) and a terminal chamber cover (22) each with an encircling sealing surface,
- the terminal chamber lower part (20) and the terminal chamber cover (22) enclose the terminal chamber (18),
- the terminal chamber lower part (20) has a base and at least one first side wall (46) and the first side wall (46) has an entry opening (48) for cable and/or plug passage into the terminal chamber (18),
- the clamping chamber cover (22) has a lid and at least one first side wall (32) and the first side wall (32) has a guide opening (30) with a third diameter D3,
- the connecting part (28) of the head part (12) projects through the guide opening (30) of the terminal chamber cover (22) into the connecting part (16),
- the first outer diameter D1 of the retaining section of the connecting part (28) is larger than the third diameter D3 of the guide opening (30),
- the second outer diameter D2 of the middle section (36) of the connecting part (28) is smaller than the third diameter D3 of the guide opening (30),
- the retaining section (34) of the connecting part (28) has a first abutment surface (38) facing the back wall outer surface (26) of the head part (12),
- the connecting part (16) has at an inner surface of the first side wall (32) and around the guide opening (30) a second abutment surface (40) as a counter-member to the first abutment surface (38) of the connecting part (28),
- the clamping chamber lower part (20) has a blocking region (42) with a side surface adjoining the first abutment surface (38) of the retaining section of the connecting part,
- so that the connecting part (28) when the clamping chamber lower part (20) is separated from the clamping chamber cover (22) is movable between a first position with first abutment surface (38) of the connecting part (28) and second abutment surface (40) of the side wall (32) lying one on the other and a second position with back wall outer surface (26) of the head part (22) bearing against the first side wall (32) of the terminal chamber cover (22), and the connecting part (28) when the clamping chamber cover (22) is connected with the clamping chamber lower part (20) is fixed in the second position in which the two sealing surfaces are connected together by interlocking.

2. Sensor casing (10) according to claim 1, **characterised in that** at least one adjusting aid (50) is arranged in a region, which directly adjoins the back wall outer surface (26), of the middle section (36) of the connecting part (28) and the first side wall (32) of the terminal chamber cover (22) has on an outer surface at least one recess (52) directly connected with the guide opening (30) and corresponding with the shape according to the adjusting aid (50).

3. Sensor casing (10) according to claim 2, **characterised in that** the guide opening (30) and a region, which directly adjoins the back wall outer surface (26), of the middle section (36) each have an at least two-fold rotational symmetry or an at least four-fold rotational symmetry.

4. Sensor casing (10) according to any one of the preceding claims, **characterised in that** the connecting part (28) is of cylindrical configuration.

5. Inductive proximity sensor or capacitive proximity sensor, wherein the proximity sensor comprises a sensor casing (10) according to any one of the preceding claims.

## Revendications

1. Boîtier de capteur (10) comprenant un élément de tête avec un espace de capteur (14) destiné à recevoir un capteur et un élément de connexion (16) avec un bornier (18) destiné à recevoir un bloc de connecteurs à borne,
dans lequel
- l'élément de tête (12) présente une paroi arrière avec une surface extérieure de paroi arrière (26) et un élément de liaison (28) disposé sur la surface extérieure de paroi arrière (26),
- l'élément de liaison (28) présente, le long d'un axe de liaison (A) courant perpendiculairement à la surface extérieure de paroi arrière (26), à une extrémité opposée à la surface extérieure de paroi arrière (26), un segment de retenue (34) doté d'un premier diamètre extérieur D1,
- l'élément de liaison (28) présente un deuxième diamètre extérieur D2 dans un segment médian (36) s'étendant entre la surface extérieure de paroi arrière (26) et le segment de retenue (34),
- le premier diamètre extérieur D1 est supérieur au deuxième diamètre extérieur D2,
- l'élément de tête (12) présente une ouverture de passage (44) courant le long de l'axe de liaison entre l'élément de liaison (28) et la paroi arrière pour le passage de câbles et/ou de broches dans l'espace de capteur (14),
- l'élément de connexion (16) est constitué de deux parties avec un socle de bornier (20) et un couvercle de bornier (22) présentant chacun une surface d'étanchéité périphérique,
- le socle de bornier (20) et le couvercle de bornier (22) entourent le bornier (18),
- le socle de bornier (20) comporte un fond et au moins une première paroi latérale (46) et la première paroi latérale (46) comporte une ouverture d'entrée (48) pour le passage de câbles et/ou de broches dans le bornier (18),
- le couvercle de bornier (22) comporte une couverture et au moins une première paroi latérale (32) et la première paroi latérale (32) comporte une ouverture de guidage (30) dotée d'un troisième diamètre D3,
- l'élément de liaison (28) de l'élément de tête (12) pénètre à travers l'ouverture de guidage (30) du couvercle de bornier (22) dans l'élément de connexion (16),
- le premier diamètre extérieur D1 du segment de retenue de l'élément de liaison (28) est supérieur au troisième diamètre D3 de l'ouverture de guidage (30),
- le deuxième diamètre extérieur D2 du segment médian (36) de l'élément de liaison (28) est inférieur au troisième diamètre D3 de l'ouverture de guidage (30),
- le segment de retenue (34) de l'élément de liaison (28) comporte une première surface de butée (38) orientée vers la surface extérieure de paroi arrière (26) de l'élément de tête (12),
- l'élément de connexion (16) comporte, sur une surface intérieure de la première paroi latérale (32), autour de l'ouverture de guidage (30), une deuxième surface de butée (40) faisant pendant à la première surface de butée (38) de l'élément de liaison (28),
- le socle de bornier (20) comporte une zone de blocage (42) avec une face latérale contigüe à la première surface de butée (38) du segment de retenue de l'élément de liaison,
- de sorte que, lorsque le socle de bornier (20) est séparé du couvercle de bornier (22), l'élément de liaison (28) peut se déplacer entre une première position dans laquelle la première surface de butée (38) de l'élément de liaison (28) et la deuxième surface de butée (40) de la paroi latérale sont posées l'une sur l'autre et une deuxième position dans laquelle la surface extérieure de paroi arrière (26) de l'élément de tête (12) repose contre la première paroi latérale (32) du couvercle de bornier (22) et, lorsque le couvercle de bornier (22) est relié au socle de bornier (20), l'élément de liaison (28) est fixé dans la deuxième position dans laquelle le deux surfaces d'étanchéité sont reliées entre elles par complémentarité de formes.

2. Boîtier de capteur (10) selon la revendication 1, **caractérisé en ce qu'**au moins un accessoire de réglage (50) est disposé dans une zone du segment médian (36) de l'élément de liaison (28) immédiatement contigüe à la surface extérieure de paroi arrière (26) et la première paroi latérale (32) du couvercle de bornier (22) présente sur une face extérieure au moins une cavité (52) immédiatement voisine de l'ouverture de guidage (30) et d'une forme correspondant à l'accessoire de réglage (50).

3. Boîtier de capteur (10) selon la revendication 2, **caractérisé en ce que** l'ouverture de guidage (30) et une zone du segment médian (36) immédiatement contigüe à la surface extérieure de paroi arrière (26) présentent chacune une symétrie de rotation à au moins deux chiffres ou une symétrie de rotation à au moins quatre chiffres.

4. Boîtier de capteur (10) selon une des revendications précédentes, **caractérisé en ce que** l'élément de liaison (28) est de forme cylindrique.

5. Capteur de proximité inductif ou capteur de proximité capacitif, lequel capteur de proximité comporte un boîtier de capteur (10) selon une des revendications précédentes.
